# EUROPÄISCHE PATENTSCHRIFT

(11) **EP 2 608 286 B1**
(45) Veröffentlichungstag und Bekanntmachung des Hinweises auf die Patenterteilung: **13.11.2019**
(21) Anmeldenummer: 11195202.4
(22) Anmeldetag: 22.12.2011
(51) Int. Cl.: H01L 41/09, H02N 2/00

(54) **ULTRASCHALLAKTOR**
ULTRASONIC ACTUATOR
ACTIONNEUR À ULTRASONS

(30) Priorität: 22.12.2011 DE 102010055848
(43) Veröffentlichungstag der Anmeldung: 26.06.2013
(73) Patentinhaber: Physik Instrumente (PI) GmbH & Co. KG, 76228 Karlsruhe (DE)
(72) Erfinder: Wischnewskiy, Wladimir, 77337 Waldbronn (DE); Wischnewskij, Alexej, 76744 Wörth (DE)
(74) Vertreter: Schatt, Markus F.

(56) Entgegenhaltungen:
- WO-A1-01/13505
- DE-A1-102008 012 992
- US-A- 5 032 753

## Beschreibung

Die vorliegende Erfindung betrifft einen Ultraschallaktor und einen solchen Ultraschallaktor aufweisenden Ultraschallmotor.

Aus den Druckschriften WO 01/13505 A1, DE 10 2008 012992 A1, US 5 032 753, US 5,616,980, US 5,777,423 und US 6,978,934 sind beispielsweise Ultraschallaktoren in Form piezoelektrischer Platten bekannt, welche mittels akustischer Stehwellen einen entsprechenden Antrieb realisieren. Hierzu weist der Aktor zwei Generatoren für die akustischen Stehwellen auf, wobei jeder von ihnen beispielsweise gleichzeitig die erste Mode einer akustischen Längsstehwelle und die zweite Mode einer akustischen Biegestehwelle erzeugt. WO 01/13505 A1 lehrt weiters einen Motor beruhend auf der gleichzeitigen voneinander unabhängigen elektrischen Erregung eines rechteckigen piezoelektrischen Oszillators hinsichtlich reiner stehender Längswellen und Biegewellen, in dem eine erste Elektrodengruppe einen Generator der zweiten Mode der akustischen Längswelle bildet und eine zweite Elektrodengruppe einen Generator der fünften Mode der akustischen Biegewelle bildet. Bei einem Längen/Breiten-Verhältnis von etwa 10 sind die Resonanzfrequenzen dieser Schwingungen gleich.

Der Nachteil der zuvor beschriebenen Ultraschallaktoren bzw. der damit realisierten Ultraschallmotoren liegt darin, dass - um eine bestimmte Bewegungsgeschwindigkeit bzw. Zugkraft zu erzeugen - eine relativ hohe Erregerspannung bzw. relativ große Aktor- oder Motorabmessungen notwendig ist bzw. sind.

Daher ist es Aufgabe der Erfindung, einen Ultraschallaktor und einen Ultraschallmotor mit einem solchen Ultraschallaktor bereitzustellen, der jeweils mit vergleichsweise niedrigen Erregerspannungen und geringen Abmessungen in der Lage ist, hohe Bewegungsgeschwindigkeiten und Zugkräfte zu erzielen.

Die zuvor genannte Aufgabe wird gelöst durch einen Ultraschallaktor und einen Ultraschallmotor mit den Merkmalen des unabhängigen Anspruchs 1. Vorteilhafte Ausgestaltungen ergeben sich aus den abhängigen Patentansprüchen.

Im Folgenden werden die Begriffe ,Aktor für einen Ultraschallmotor', ,Ultraschallaktor' oder auch nur ,Aktor' synonym verwendet.

Grundlegende Idee der Erfindung ist es, in dem Ultraschallaktor gleichzeitig die zweite Mode einer Längsstehwelle und die fünfte Mode einer Biegestehwelle anzuregen. Durch die gleichzeitige Ausbreitung dieser beiden Wellen erfolgt im Aktor eine Überlagerung der entsprechend hervorgerufenen Deformationen. Da die Längswelle zu Längsschwingungen der Materialpunkte des Aktors führt und die Biegewelle Biegeschwingungen bewirkt, bewegt sich ein an dem Aktor angeordnetes Friktionselement auf geneigten linearen oder elliptischen Bewegungsbahnen. Die Form dieser Bewegungsbahnen wird durch den Phasenverschiebungswinkel zwischen der Längs- und der Biegewelle bestimmt. Besagte geneigte lineare oder elliptische Bewegungsbahnen der Schwingungen des Friktionselements führen zu einer gleichgerichteten Lageverschiebung eines durch den Ultraschallaktor anzutreibenden Elements, dessen Friktionsschicht an das Friktionselement angepresst ist. Dabei gibt die Längswelle ihre Energie an die mechanische Last des anzutreibenden Elements ab und stellt diesbezüglich die Zugwelle dar. Die Biegewelle bewirkt ein periodisches Anpressen des Friktionselements an die Friktionsschicht des anzutreibenden Elements.

Durch die Verwendung einer Längswelle als Zugwelle ergibt sich ein sehr effektiv einsetzbarer Ultraschallaktor, da die Längswelle einen höheren elektromechanischen Koppelkoeffizienten als eine Biegewelle aufweist. Daher kann der erfindungsgemäße Ultraschallaktor mit einer vergleichsweise geringen Erregerspannung betrieben werden, um das anzutreibende Element mit einer bestimmten Geschwindigkeit zu bewegen bzw. um auf das anzutreibende Element eine bestimmte Zugkraft aufzubringen. Anders herum ausgedrückt ist bei gleichbleibender Erregerspannung der erfindungsgemäße Ultraschallaktor im Vergleich zu einem Ultraschallaktor gemäß dem Stand der Technik in der Lage, das anzutreibende Element mit einer deutlich höheren Geschwindigkeit zu bewegen bzw. eine deutlich höhere Zugkraft auf das anzutreibende Element zu übertragen. Zudem besitzt der erfindungsgemäße Ultraschallaktor eine kleinere minimale Ansprechgrenze bezüglich der Bewegungsgeschwindigkeit, wodurch sich die Auflösungsfähigkeit und die Positionierungsgenauigkeit eines entsprechenden Ultraschallmotors, welcher den erfindungsgemäßen Ultraschallaktor umfasst, erhöhen.

Der erfindungsgemäße Ultraschallaktor hat die Form einer piezoelektrischen Platte der Länge L, der Höhe H und mit einer Quer-Symmetrieebene S, die senkrecht zur Längsrichtung des Ultraschallaktors durch dessen Mitte verläuft. Der Ultraschallaktor umfasst weiterhin zwei Generatoren für akustische Stehwellen, und an dem Ultraschallaktor ist wenigstens ein Friktionselement zum Antrieb eines anzutreibenden Elements angeordnet ist.

Den erfindungsgemäßen Ultraschallaktor zeichnet aus, dass die Länge L und die Höhe H der piezoelektrischen Platte derart bemessen sind, dass die Resonanzfrequenz fₗ der zweiten Mode der Längswelle im Wesentlichen identisch zu der Resonanzfrequenz f_{b} der fünften Mode der Biegestehwelle ist. Zudem umfasst jeder der Generatoren zwei Teile, die auf unterschiedlichen Seiten der Quer-Symmetrieebene S angeordnet sind, wobei jeder der Generatoren gleichzeitig in dem Ultraschallaktor eine sich jeweils längs der Plattenlänge L ausbreitende Längsstehwelle und Biegestehwelle erzeugt.

Es kann sich als zweckmäßig erweisen, dass bei dem erfindungsgemäßen Ultraschallaktor das Verhältnis L/H im Wesentlichen gleich zehn ist.

Zudem kann es sich als zweckmäßig erweisen, dass die piezoelektrische Platte des Ultraschallaktors die Form eines Rechtecks oder eines Ringsegments hat.

Weiterhin kann es sich als zweckmäßig erweisen, dass der Ultraschallaktor einen Sensor für die durch die Biegestehwelle im Ultraschallaktor erzeugte elektrische Spannung aufweist, der im zentralen Teil der piezoelektrischen Platte symmetrisch zur Quer-Symmetrieebene S angeordnet ist.

Es kann vorteilhaft sein, dass das wenigstens eine Friktionselement des Ultraschallaktors an einer Längsseitenfläche der piezoelektrischen Platte angeordnet ist.

Die Erfindung umfasst ebenso einen Ultraschallmotor mit wenigstens einem Ultraschallaktor gemäß den zuvor beschriebenen Ausführungsformen.

Hierbei kann es vorteilhaft sein, dass der Ultraschallmotor ein anzutreibendes Element und eine elektrische Erregervorrichtung zur elektrischen Ansteuerung des Ultraschallaktors umfasst.

Ebenso kann es vorteilhaft sein, dass der Ultraschallmotor eine Klemmvorrichtung zum Anpressen des wenigstens einen Friktionselements an das anzutreibende Element aufweist, wobei die Klemmvorrichtung mindestens ein Klemmelement und mindestens ein Federelement umfasst.

Außerdem kann es vorteilhaft sein, dass das mindestens eine Klemmelement im Bereich des Minimums der Längsverschiebungen der sich in der piezoelektrischen Platte ausbreitenden akustischen Längsstehwelle angeordnet ist.

Darüber hinaus kann es vorteilhaft sein, dass das anzutreibende Element längs seiner Längsrichtung oder quer zu seiner Längsrichtung oder geneigt zu seiner Längsrichtung angeordnete Nuten, die vorzugsweise mit einem Material niedriger mechanischer Güte wie beispielsweise Oxidkeramik, poröse Keramik, Epoxidharz oder elastomeres Material ausgefüllt sind, zur Unterdrückung von parasitären akustischen Wellen aufweist.

Es kann sich als günstig erweisen, dass das anzutreibende Element mehrschichtig ist und zumindest eine Dämpfungsschicht aufweist, die parallel und/oder senkrecht zu einer an der Oberfläche des anzutreibenden Elements angeordneten Friktionsschicht angeordnet ist..

Zudem kann es sich als günstig erweisen, dass das anzutreibende Element wenigstens ein Dämpfungselement aufweist.

Es kann sich ebenso als günstig erweisen, dass das Dämpfungselement ein piezoelektrisches Material, vorzugsweise in Form einer piezoelektrischen Platte, aufweist.

Hierbei kann es sich als günstig erweisen, dass das Dämpfungselement Elektroden aufweist, die mit die elektrische Energie streuenden Widerständen oder mit einer Vorrichtung zur Erzeugung einer gegenphasigen elektrischen Spannung verbunden sind.

Es kann von Vorteil sein, dass die elektrische Erregervorrichtung einen selbsterregenden Generator darstellt, dessen Erregung durch das Signal des Sensors für die durch die Biegestehwelle im Ultraschallaktor erzeugte elektrische Spannung erfolgt oder mit einem Signal des Sensors synchronisiert ist.

Weiterhin kann es von Vorteil sein, dass die elektrische Erregervorrichtung aus einem Steuergenerator für eine elektrische Spannung besteht, dessen Erregerfrequenz durch die Phase des Signals des Sensors für die durch die Biegestehwelle im Ultraschallaktor erzeugte elektrische Spannung gesteuert ist.

### Kurze Beschreibung der Zeichnungen

Es zeigen in schematischer und nicht maßstabsgetreuer Weise:
Fig. 1: Erfindungsgemäßer Ultraschallaktor innerhalb eines entsprechenden Ultraschallmotors
Fig. 2, 3: Geometrien und Elektrodenanordnung eines erfindungsgemäßen Ultraschallaktors
Fig. 4: Verdeutlichung der durch die Generatoren des Ultraschallaktors in diesem erzeugten Längs- und Querverschiebungen
Fig. 5: Darstellungen 36 bis 39: unterschiedliche Ausführungsformen des erfindungsgemäßen Ultraschallaktors
Fig. 6: Ultraschallaktor mit mehrschichtigem Aufbau; Darstellung 40: Elektrodenanordnung, Darstellung 41: Polarisationsschema
Fig. 7, 8: Darstellungen 42 bis 46: Verdeutlichung unterschiedlicher Elektrodenanordnungen bzw. Polarisationsvarianten eines erfindungsgemäßen Ultraschallaktors und entsprechende elektrische Ansteuerung
Fig. 9-11: Darstellungen 53 bis 60: Unterschiedliche Ausführungsformen eines erfindungsgemäßen Ultraschallaktors in Form eines Ringsegments
Fig. 12-14: Erfindungsgemäßer Ultraschallaktor mit einem Sensor für die durch die Biegestehwelle im Ultraschallaktor erzeugte elektrische Spannung
Fig. 15: Darstellungen 72 bis 74: Unterschiedliche Ausführungsformen des anzutreibenden Elements
Fig. 16: Darstellungen 78 bis 80: Unterschiedliche Ausführungsformen eines mehrschichtigen anzutreibenden Elements
Fig. 17: Weitere Ausführungsform eines mehrschichtigen anzutreibenden Elements
Fig. 18, 19: Unterschiedliche Ausführungsformen des anzutreibenden Elements mit daran angeordneten Dämpfungselementen
Fig. 20: Darstellung 89: Ausführungsform des Dämpfungselements als dünne piezokeramische Platte mit entsprechender elektrischer Verbindung; Darstellungen 95 und 97: Unterschiedliche elektrische Verschaltung des Dämpfungselements gemäß Darstellung 89
Fig. 21: Darstellungen 99 bis 101: Unterschiedliche Ausführungsformen der Klemmvorrichtung zum Anpressen des Friktionselements des Ultraschallaktors an das anzutreibende Element
Fig. 22: Ultraschallmotor mit erfindungsgemäßem Ultraschallaktor, der zwei Friktionselemente aufweist
Fig. 23: Ultraschallmotor mit erfindungsgemäßem Ultraschallaktor, der vier Friktionselemente aufweist
Fig. 24: Ultraschallmotor mit zwei gegenüberliegend angeordneten erfindungsgemäßen Ultraschallaktoren und einem anzutreibenden Element in Form einer Platte
Fig. 25: Ultraschallmotor mit zwei gegenüberliegend angeordneten erfindungsgemäßen Ultraschallaktoren und einem rundstabförmigen anzutreibenden Element
Fig. 26, 27: Unterschiedliche Ausführungsformen eines Ultraschallmotors mit einem erfindungsgemäßen Ultraschallaktor in Plattenform und einem scheibenförmigen anzutreibenden Element
Fig. 28: Erfindungsgemäßer Ultraschallaktor in Form eines Ringsegments mit einem scheibenförmigen anzutreibenden Element
Fig. 29: Erfindungsgemäßer Ultraschallaktor in Form eines Ringsegments mit einem ringförmigen anzutreibenden Element
Fig. 30, 31: Blockschaltbilder für unterschiedliche Ausführungsformen der Erregervorrichtung zur einphasigen Ansteuerung eines Generators des erfindungsgemäßen Ultraschallaktors
Fig. 32: Blockschaltbild der Erregervorrichtung zur zweiphasigen Ansteuerung eines Generators des erfindungsgemäßen Ultraschallaktors
Fig. 33: Blockschaltbild der Erregervorrichtung zur gleichzeitigen zweiphasigen Ansteuerung zweier Generatoren des erfindungsgemäßen Ultraschallaktors
Fig. 34-37: Darstellungen 123 bis 130: Simulation der beiden Phasen maximaler Deformation eines erfindungsgemäßen Ultraschallaktors mit unterschiedlicher Anzahl von Friktionselementen

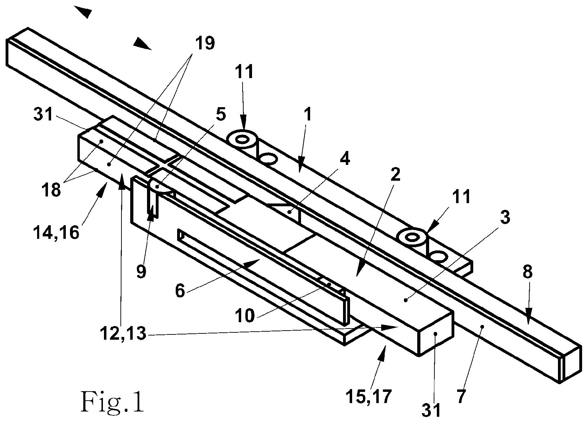

Fig. 1 zeigt einen Ultraschallmotor mit erfindungsgemäßen Ultraschallaktor 2, welcher auf dem Gehäuse 1 angeordnet ist. Der Ultraschallaktor 2 umfasst eine piezoelektrische Platte 3 mit Hauptflächen 18, Längsseitenflächen 19 und Stirnseitenflächen 31. An einer Längsseitenfläche 19 ist ein Friktionselement 4 in Form eines Dreiecks mit abgeflachter Spitze angeordnet. Mit dem Gehäuse einstückig ausgeführt ist eine Klemmvorrichtung zum Anpressen des Friktionselements 4 an eine Friktionsschicht 7 eines anzutreibenden Elements 8. Die Klemmvorrichtung besitzt eine Öffnung 9, in welcher das Klemmelement 5 gehaltert ist. Zudem umfasst die Klemmvorrichtung ein Federelement 6 und eine schallisolierende Zwischenlage 10, über welche das Federelement 6 den Ultraschallaktor 2 in Richtung des anzutreibenden Elements 8 drückt. Am Gehäuse 1 angeordnet sind weiterhin zwei Lagerelemente 11 in Form von Zylinderrollenlagern zur beweglichen Lagerung des anzutreibenden Elements 8. Die piezoelektrische Platte 3 weist zwei Generatoren 12, 13 zur Erzeugung akustischer Stehwellen auf, wobei jeder der Generatoren 12, 13 jeweils in zwei Teile 14, 15 und 16, 17 geteilt ist.

Das anzutreibende Element 8 hat die Form eines Rechteckstabs, jedoch sind weitere Ausführungsformen für das anzutreibende Element 8, etwa ein Rundstab, ein Rohr, eine rechteckige Platte, eine Scheibe, ein Ring, ein Halbring oder eine Kugel, möglich. Das anzutreibende Element 8 weist ein oxidkeramisches Material auf, es kann jedoch ebenso ein Metall, eine Metallkeramik oder ein polymeres Material, insbesondere ein thermoplastisches Material, aufweisen oder aus diesem bestehen. Die Friktionsschicht 7 weist Al₂0₃ auf, sie kann jedoch alternativ ZrO₂, SiC, Si₃ N₄, WC, Al₂TiO₅, Cr, CrN, CrCN, (Cr,W)N, (Cr,Al)N, NbN-CrN, TiN, TiCN, (Ti,Al)N oder V₂O₅ aufweisen.

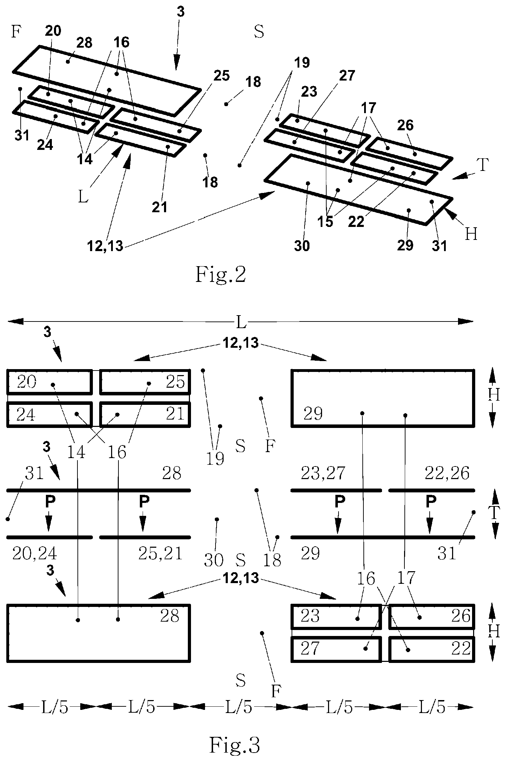

Fig. 2 verdeutlicht die Geometrien des erfindungsgemäßen Ultraschallaktors 2. Durch die Mitte der piezoelektrischen Platte 3 verläuft senkrecht zu den Hauptflächen 18 und den Längsseitenflächen 19 und parallel zu den Stirnseitenflächen 31 die Quer-Symmetrieebene S. Parallel zu den Längsseitenflächen 19 und senkrecht sowohl zu den Hauptflächen 18, als auch zu den Stirnseitenflächen 31 verläuft die Trennebene F, die im vorliegenden Fall einer rechteckigen piezoelektrischen Platte eine Längs-Symmetrieebene darstellt. Die piezoelektrische Platte 3 weist die Höhe H, die Länge L und die Dicke T auf. Die Länge L und die Höhe H sind derart bemessen bzw. gewählt, dass die Resonanzfrequenz fₗ der zweiten Mode der im Aktor erzeugten Längsstehwelle (bezogen auf die Länge L) im Wesentlichen mit der Resonanzfrequenz f_{b} der fünften Mode der Stehbiegewelle (bezogen auf die Länge L) zusammenfällt bzw. mit dieser identisch ist. Das bedeutet, dass die Länge L gleich oder nahezu gleich der Wellenlänge der akustischen Längsschwingungen ist, und dass die Länge L gleich oder nahezu gleich der 2,5-fachen Wellenlänge der akustischen Biegeschwingungen ist. Diese Bedingung wird dann erfüllt, wenn das Verhältnis L/H im Wesentlichen 10 beträgt, wobei das Verhältnis L/H auch vom Typ der piezoelektrischen Keramik des Ultraschallaktors abhängt bzw. sich mit dieser geringfügig ändert.

Bei der hier verwendeten piezoelektrischen Keramik des Typs PIC 181 der Fa. PI Ceramic GmbH, Lederhose, beträgt die Frequenzkonstante Nₗ in etwa 3376 kHz mm, woraus sich über die Formel Nₗ = L · fₗ die Resonanzfrequenz fₗ bestimmen lässt.

Zur Erregung der akustischen Stehwellen im Ultraschallaktor 2 weist die piezoelektrische Platte 3 zwei Generatoren 12, 13 auf, wobei jeder Generator in zwei Teile 14, 15 bzw. 16, 17 geteilt ist, und die Teile 14, 15 und die Teile 16, 17 auf verschiedenen Seiten der Quer-Symmetrieebene S angeordnet sind.

Bei der dargestellten Dreischichtstruktur weist das Teil 14 die beiden Erregerelektroden 20, 21, die allgemeine Elektrode 28 und die dazwischen angeordnete Piezokeramikschicht 30 auf, während das Teil 15 die beiden Erregerelektroden 22, 23, die allgemeine Elektrode 29 und wiederum die zwischen diesen Elektroden angeordnete Piezokeramikschicht 30 auf. Das Teil 16 umfasst die beiden Erregerelektroden 24, 25, die allgemeine Elektrode 28 und die dazwischen angeordnete Piezokeramikschicht 30, und das Teil 17 schließlich umfasst die Erregerelektroden 26, 27, die allgemeine Elektrode 29 und die dazwischen angeordnete Piezokeramikschicht 30.

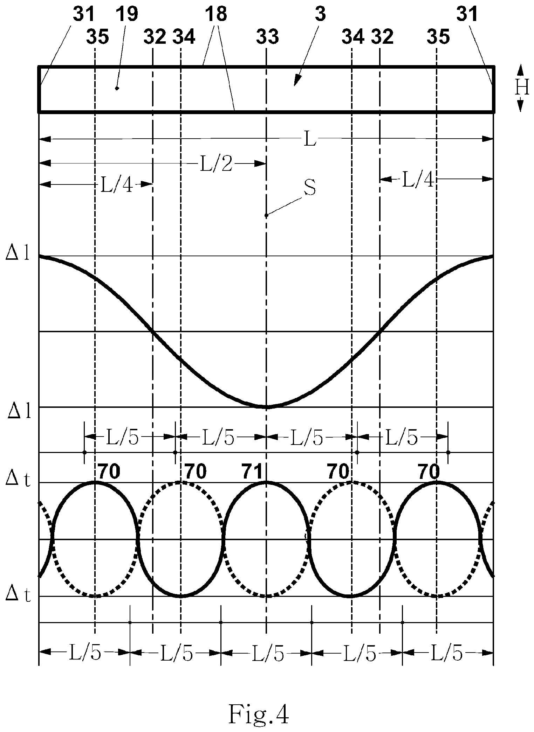

Die Länge jeder der Elektroden 20 bis 27 ist etwa gleich L/5. Diese Elektroden sind in Bereichen seitlicher Biegehalbwellen angeordnet, und zwar auf verschiedenen Seiten der Trennebene F. Die Anordnung der Elektroden 20 bis 27 zusammen mit den Elektroden 28 und 29 ermöglicht es, mit Hilfe jedes der Generatoren 12, 13 im Aktor 2 gleichzeitig eine Längsstehwelle und eine Biegestehwelle zu erzeugen. Da die Teile 14 und 15 des Generators 12 das Spiegelbild - bezogen auf Trennebene F - der Teile 16 und 17 des Generators 13 darstellen, sind die durch diese Generatoren erzeugten Längsstehwellen in Phase und die erzeugten Biegestehwellen in Gegenphase (siehe auch Fig. 4).

Anhand Fig. 3 ist die Richtung des Polarisationsvektors P innerhalb der Piezokeramikschicht 30 des Ultraschallaktors gemäß Fig. 2 verdeutlicht. Dabei ist der Polarisationsvektor für beide Generatoren im Wesentlichen senkrecht zu den Elektroden und in gleicher Richtung (parallel) ausgerichtet. Eine antiparallele Ausrichtung ist ebenso denkbar.

Fig. 4 verdeutlicht die durch die Generatoren 12, 13 des Ultraschallaktors 2 in diesem erzeugten Längs- und Querverschiebungen. Die Linien 32 geben hierbei die Lage der Minima der Längsverschiebungen DI an, d.h. die Lage der Minima der Schwingungsgeschwindigkeiten der Längsstehwelle. Die Linie 33 gibt die Lage der zentralen Maxima der Längsverschiebungen an, d.h. die Maxima der Schwingungsgeschwindigkeiten der Längsstehwelle und der Biege-Stehwelle. Die Linien 34 und 35 geben die Lage der Seitenmaxima der Querverschiebungen Dt an, d.h. der Maxima der Schwingungsgeschwindigkeiten der Biegestehwelle.

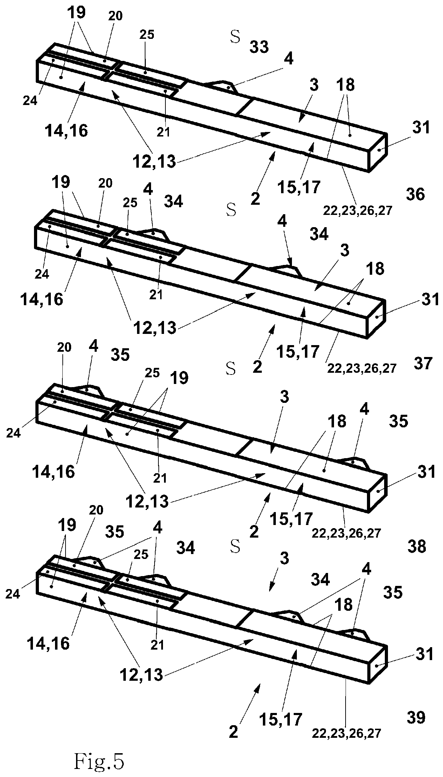

Gemäß Fig. 5 kann der erfindungsgemäße Ultraschallaktor 2 ein Friktionselement (Darstellung 36) oder mehrere Friktionselemente (Darstellungen 37 bis 39) aufweisen. Dabei ist das Friktionselement bzw. sind die Friktionselemente 4 auf einer der Längs-Seitenflächen 19 im Maximum der Querverschiebungen angeordnet, d.h. an Stellen der maximalen Schwingungsgeschwindigkeiten der Biegestehwelle, gekennzeichnet durch die Linien 33 bis 35. Die Anordnung der Friktionselemente 4 ist hierbei symmetrisch zur Quer-Symmetrieebene S.

Das Friktionselement 4 hat die Form eines Dreiecks mit abgeflachter Spitze. Jedoch sind vielfältige weitere geometrische Ausgestaltungen des Friktionselements 4 möglich, z.B. eine Pyramidenform, eine Rechteck- oder Quadratform, eine Zylinderform oder eine Kugel- bzw. Halbkugelform. Das Friktionselement 4 besteht aus einer harten Oxidkeramik auf Basis von Al₂O₃. Weitere harte Oxidkeramiken auf Basis von ZrO₂, SiC, Si₃N₄ sind ebenfalls denkbar. Zudem kann das Friktionselement 4 auch aus einem anderen abriebfesten Material bestehen, beispielsweise aus einer harten Metallkeramik auf der Basis von WC, Al₂TiO₅, oder ähnlichem.

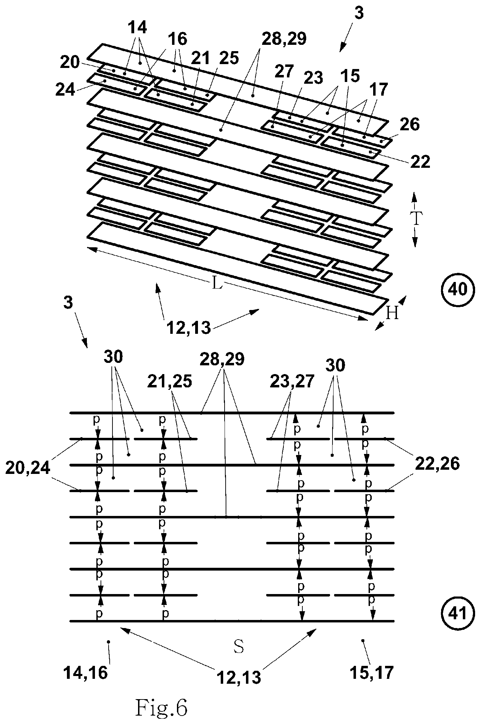

Wie in den Darstellungen 40 und 41 von Fig. 6 verdeutlicht, kann der erfindungsgemäße Ultraschallaktor nicht nur dreischichtig mit zwei Elektrodenschichten und einer zwischen den Elektroden angeordneten Piezokeramikschicht sein, sondern kann eine Vielzahl der zuvor beschriebenen Schichten aufweisen. Hierbei zeigt Darstellung 40 eine entsprechende beispielhafte Anordnung der Elektroden 20 bis 29, während Darstellung 41 ein beispielhaftes Polarisationsschema der Piezokeramikschichten 30 aufzeigt.

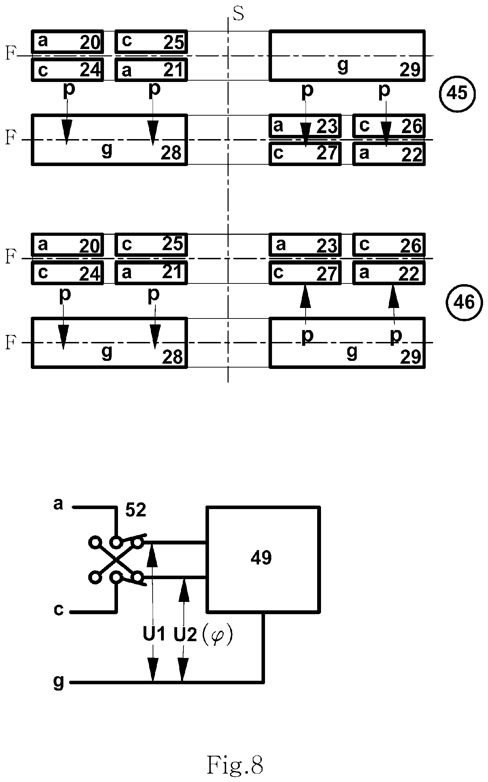

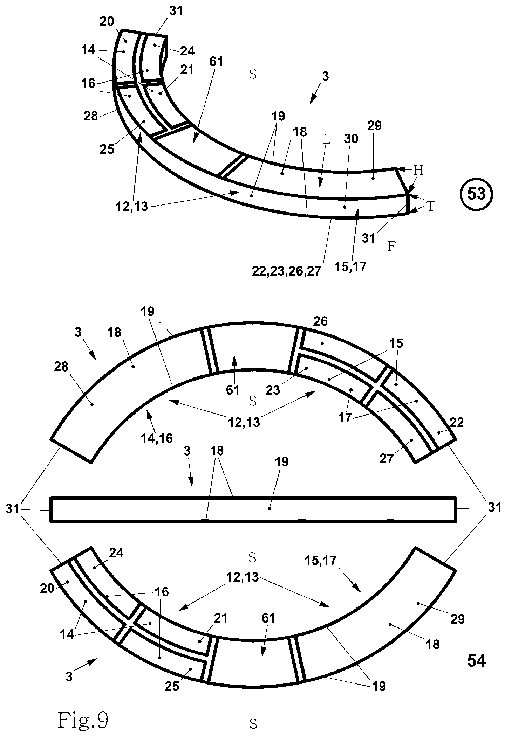

Die Fig. 8 und 9 zeigen in den Darstellungen 42 bis 46 verschiedene Ausführungsformen zur Anordnung der Elektroden 20 bis 29 zusammen mit möglichen Polarisationsrichtungen der Piezokeramikschichten 30. Hierbei kennzeichnen gleiche Buchstaben a, c, -a, -c, g gleichpolige Elektroden, die mit den entsprechenden Ausgängen der elektrischen Erregervorrichtungen 47 bis 49 verbunden sind.

Die elektrischen Erregervorrichtungen 47, 48, 49 stellen die elektrischen Spannungen U1,-U1, U2 mit gleicher Frequenz fₐ bereit, bei der im Aktor 2 die zweite Mode einer akustischen Längsstehwelle und die fünfte Mode einer akustischen Biegestehwelle generiert werden. Dafür kann die Frequenz fₐ gleich der halben Resonanzfrequenz fₗ der zweiten Mode der Längsstehwelle längs der Länge L sein oder gleich der Resonanzfrequenz f_{b} der fünften Mode der Biegestehwelle längs der Länge L sein oder nah zu einer dieser Frequenzen liegen. Die Spannungen U1, -U1, U2 können eine Sinusform, eine Dreiecksform, eine Trapezform, eine Rechteckform oder eine andere periodische Form aufweisen.

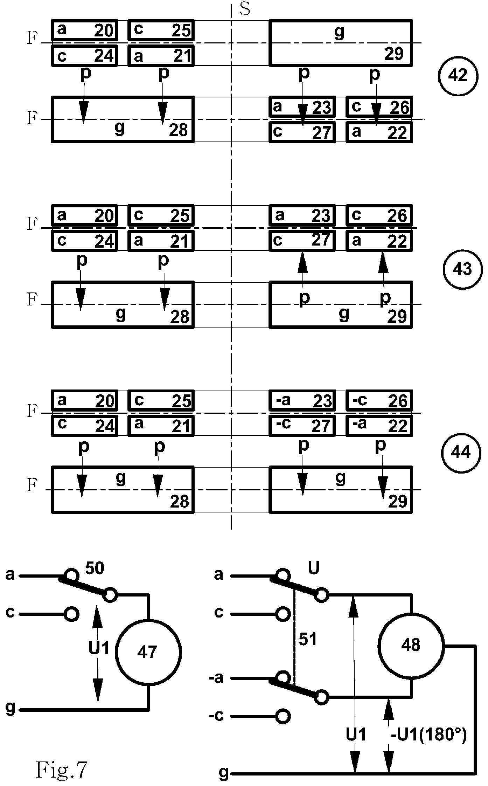

Mit Hilfe der elektrischen Erregervorrichtungen 47 in Fig. 7 erfolgt eine einphasige elektrische Erregung eines der Generatoren 12 oder 13 des Aktors 2. Dafür wird über den Umschalter 50 die elektrische Spannung U1 an die Elektroden eines der Generatoren 12, 13 gelegt, wodurch einer der Generatoren angeregt wird. Beim Umschalten des Umschalters 50 aus der einen in die andere Stellung wird die Erregung eines der Generatoren 12, 13 unterbrochen und es beginnt die Erregung des jeweils anderen Generators 12, 13. Dies führt zur Umkehr der Bewegungsrichtung des anzutreibenden Elements 8.

Mit Hilfe der elektrischen Erregervorrichtungen 48 in Fig. 7 erfolgt eine zweiphasige elektrische Erregung eines der Generatoren 12 oder 13 des Aktors 2. Dabei werden an die Elektroden eines der Generatoren 12 oder 13 zwei elektrische Spannungen U1 und -U1 angelegt, die zueinander um den Winkel 180° phasenverschoben sind. Beim Umschalten des Umschalters 51 aus der einen in die anders Stellung erfolgt eine Umkehr der Bewegungsrichtung des anzutreibenden Elements 8.

Mit Hilfe der elektrischen Erregervorrichtungen 49 in Fig. 8 erfolgt eine zweiphasige elektrische Erregung des Aktors 2. Dabei werden an die Elektroden der zwei Generatoren 12, 13 die zwei elektrischen Spannungen U1 und U2, die zueinander um den Winkel +ϕ oder - ϕ 180° phasenverschoben sind. Der Winkel ϕ kann 90° betragen oder von 90° abweichen. In diesem Fall erfolgt die Umschaltung der Bewegungsrichtung des anzutreibenden Elementes 8 mit Hilfe des Umschalters 52 durch Änderung des Winkels ϕ in die entgegen gesetzte Richtung.

Fig. 9 zeigt in Darstellung 53 einen erfindungsgemäßen Ultraschallaktor in Form eines Ringsegments, während in Darstellung 54 der gleiche Ultraschallaktor in drei weiteren Ansichten gezeigt ist. Bei dieser Ausführungsform des Ultraschallaktors beschreiben die Längsseitenflächen 19 und die Trennebene F (Teil-)Zylinderumfangsfläche. Die Länge L ergibt sich aus der mittleren Kreislinie der piezokeramischen Platte 3.

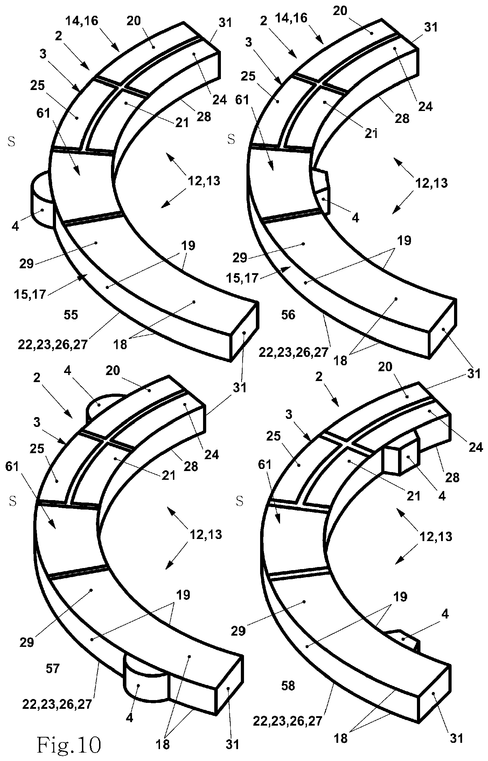

Fig. 10 verdeutlicht in den Darstellungen 55 bis 58 mehrere Möglichkeiten für die Anordnung und Ausführung des/der Friktionselements/Friktionselemente 4 bei einem erfindungsgemäßen Ultraschallaktor in Form eines Ringsegments.

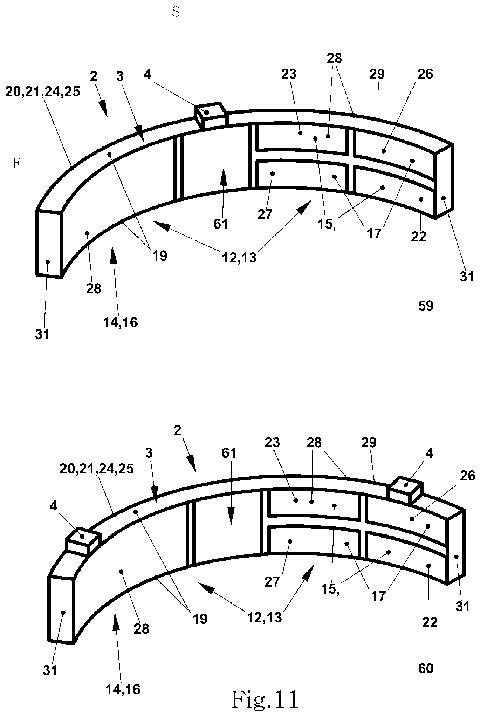

Fig. 11 zeigt in den Darstellungen 59 und 60 ebenfalls unterschiedliche Ausführungsformen eines erfindungsgemäßen Ultraschallaktors in Form eines Ringsegments, bei dem jedoch im Unterschied zu den Ultraschallaktoren gemäß Fig. 9 und 10 die Hauptflächen eine (Teil-)Zylinderumfangsfläche beschreiben.

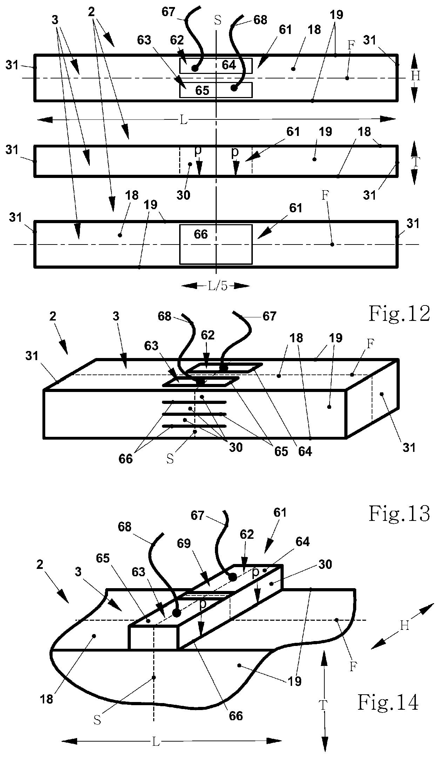

Gemäß den Fig. 12 bis 14 kann der erfindungsgemäße Ultraschallaktor einen Sensor 61 für die Detektierung der in dem Ultraschallaktor durch die Deformationen der Biegestehwelle generierten elektrischen Spannungen (elektrische Biegespannungen) aufwiesen. Hierbei ist der Sensor 61 ist im mittleren Teil der piezoelektrischen Platte 3 im zentralen Bereich, in dem die Biegehalbwelle Querverschiebungen 71 (siehe Fig. 4) bewirkt, symmetrisch zur Quer-Symmetrieebene S angeordnet.

Der Sensor 61 besteht aus den zwei Teilen 63, 63, die symmetrisch zur Trennebene F angeordnet sind. Jedes Teil weist die Elektroden 64, 65, 66 und eine Piezokeramikschicht 30 zwischen diesen auf. Die Elektroden 64 und 65 haben die Ausgänge 67 und 68. Der Sensor 61 hat in etwa die Länge L/5. Die Teile 62 und 63 des Sensors 61 können Teil der piezoelektrischen Platte 3 sein. Sie können, wie in Fig. 12 gezeigt, eine Dreischichtstruktur oder, wie in Fig. 13 dargestellt, eine Vielschichtstruktur aufweisen. Außerdem kann der Sensor 61 als einzelnes Piezoelement 69 ausgeführt sein, das in der in Fig. 14 dargestellten Weise mit der piezoelektrischen Platte 3 verbunden ist. Zur Anregung des Aktors 2 durch die elektrische Erregervorrichtung 47, 48, 49 stellt der Sensor 61eine elektrische Spannung bereit, die sich proportional zur Queramplitude der Schwingungen des Aktors 2 verhält. In der erfindungsgemäßen Ausführung wird der Sensor 61 als eine Art Amplitudengeber für die Querschwingungen des Aktors 2 eingesetzt, d. h. wie ein Amplitudengeber für die Biegestehwelle.

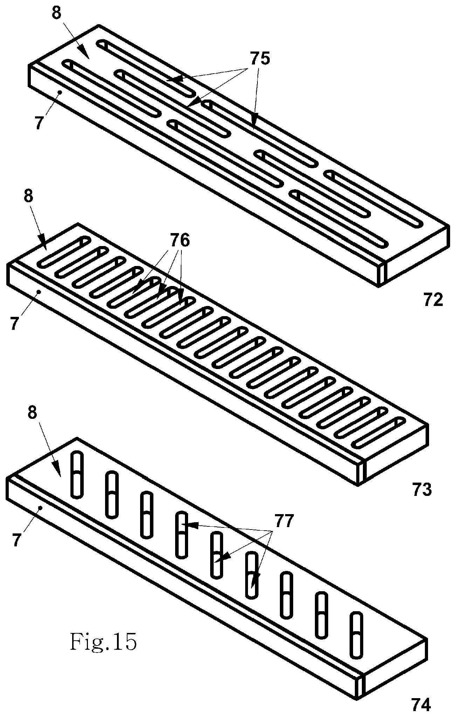

Die Darstellungen 72 bis 74 von Fig. 15 zeigen mögliche Ausführungsformen des anzutreibenden Elements 8 mit darin befindlichen Nuten 75, 76, 77 mit unterschiedlicher Orientierung bezüglich der Längsausrichtung des anzutreibenden Elements 8. Diese Nuten 75, 76, 77 unterdrücken sich im anzutreibenden Element 8 entstehende parasitäre akustische Wellen. Es ist denkbar, die Nuten 75 bis 77 mit einem Material geringer mechanischer Güte zu füllen. Ein Füllmaterial kann Oxidkeramik mit geringer Güte oder ein poröses Metall sein. Außerdem kann ein organischer Werkstoff geringer Güte, z. B. Epoxidharz, Gummi, Polyurethan, Teflon und ähnliche verwendet werden. Als Füllmaterial eingesetzt werden können ebenso Verbundmaterialien wie z. B. organisches Material, angefüllt mit harten Metallteilen, Oxidkeramik oder kristallinen Teilen.

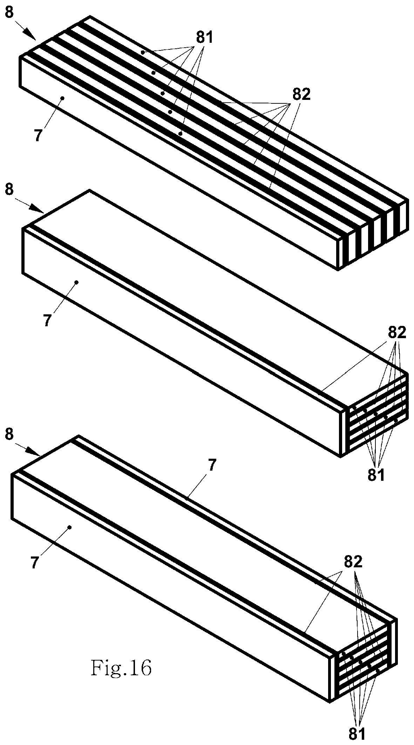

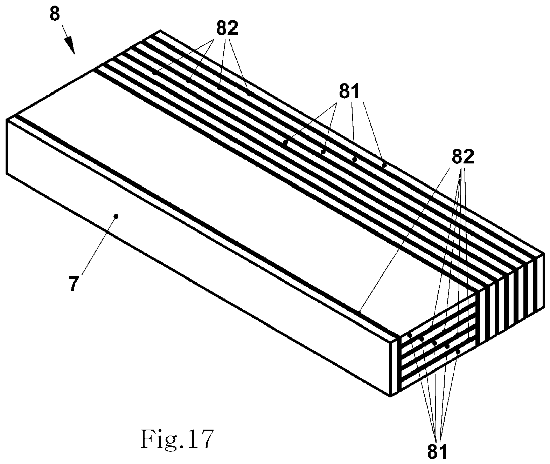

Gemäß den Darstellungen 78 bis 80 von Fig. 16 weist das anzutreibende Element 8 eine Vielschichtstruktur mit elastischen Schichten 81 und Dämpfungsschichten 82 auf. Die Schichten 81 und 82 können parallel zur Friktionsschicht 7 (Darstellung 78) oder senkrecht zur Friktionsschicht 7 (Darstellungen 79 und 80) angeordnet sein. Außerdem kann ein Teil der Schichten 81, 82 senkrecht zur Friktionsschicht 7 und ein Teil der Schichten parallel zur Friktionsschicht 7, wie in Fig. 17 dargestellt, angeordnet sein.

Die elastischen Schichten 81 können aus Oxidkeramik mit hoher Güte, aus monokristallinen Materialien oder aus Metall gefertigt sein. Dazu müssen die Materialien eine hohe mechanische Güte aufweisen. Die Dämpfungsschichten 82 können Oxidkeramik mit niedriger Güte, poröse Keramik oder poröses Metall aufweisen oder aus diesen Materialien bestehen. Außerdem können sie organisches Material niedriger Güte, Epoxidharz, Gummi, Polyurethan, und ähnliches aufweisen. Als Dämpfungsschichten eignen sich Verbundwerkstoffe wie z. B. organische Werkstoffe, verstärkt mit einem Metallnetz oder angefüllt mit harten Metallteilen, Oxidkeramik, kristallinen Teilen und ähnliche. Das Material für die Dämpfungsschichten 82 hat hierbei einen niedrigen Elastizitätsmodul.

Die vorgeschlagene Erfindung sieht vor, dass die dämpfenden Nuten 75, 76, 77 des anzutreibenden Elements 8 mit den Dämpfungsschichten 82 kombiniert werden können.

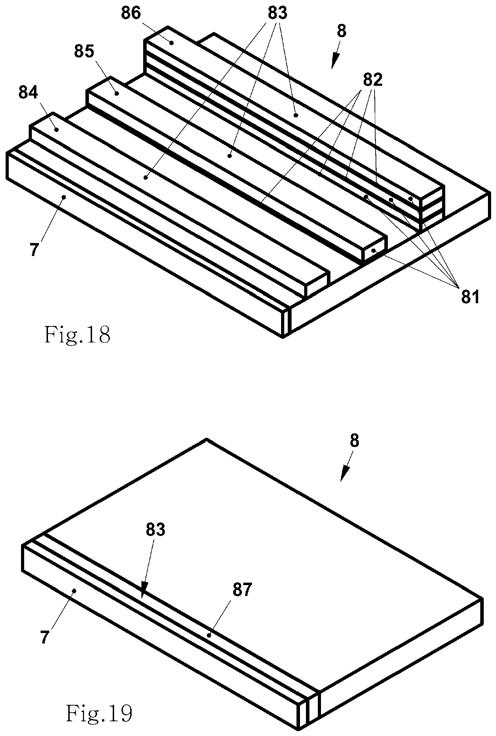

Fig. 18 zeigt ein anzutreibendes Element 8, welches an ihm angeordnete bzw. mit ihm verbundene Dämpfungselemente 83 aufweist. Die Dämpfungselemente 83 können als einschichtige Platte 84, oder als zweischichtige Platte 85, oder als Vielschichtplatte 86 mit elastischen Schichten 81 und Dämpfungsschichten 82, ausgeführt sein.

In Fig. 19 ist das Dämpfungselement 83 des anzutreibenden Elements 8 als passives Piezoelement 87 ausgeführt, das unter der Friktionsschicht 7 angeordnet ist. Das passive Piezoelement 87 kann jedoch an jeder beliebigen Stelle der Oberfläche des anzutreibenden Elements 8 oder aber im Inneren des anzutreibenden Elements 8 angeordnet sein.

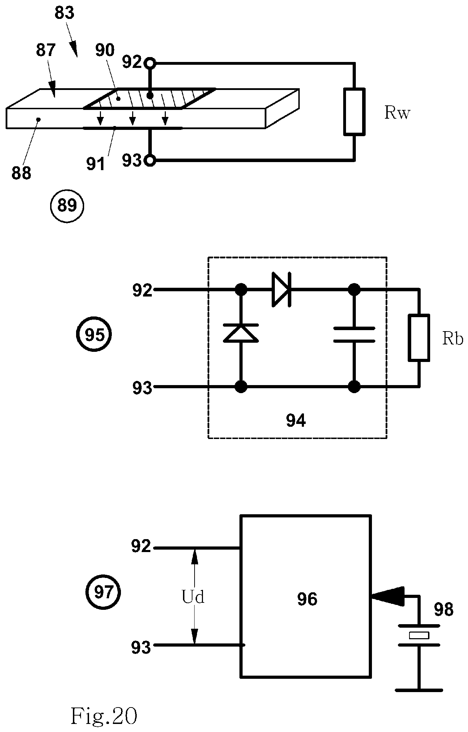

Gemäß Darstellung 89 von Fig. 20 ist das passive Piezoelement 87 als dünne piezokeramische Platte 88 mit den Elektroden 90, 91 und den Ausgängen 92, 93 ausgeführt. Zur effektiven Unterdrückung der Energie der parasitären akustischen Wellen ist an die Elektroden 90, 91 des passiven Piezoelements 87 der die Energie streuende elektrische Widerstand R_{W} angeschlossen. Die maximale Dämpfung ist möglich, wenn der Widerstandswert R_{W} gleich 1/2πfdCₒ ist, wobei f_{d} die Frequenz der unterdrückten Welle und Cₒ die elektrische Kapazität der Elektroden 90, 91 ist.

Zur effektiven Unterdrückung der Energie der parasitären akustischen Wellen ist es gemäß Darstellung 94 von Fig. 20 ebenso möglich, die Elektroden 90, 91 mit einem elektrischen Gleichrichter 94 zu verbinden, der mit dem Widerstand R_{b} einer elektrischen Nutzlast verbunden ist. In diesem Fall muss der Widerstand R_{b} gleich 1/πfdCₒ sein.

Weiterhin kann zur effektiven Unterdrückung der Energie parasitärer akustischer Wellen in dem anzutreibenden Element 8 das Prinzip der aktiven Unterdrückung dieser Wellen gemäß Darstellung 97 von Fig. 20 verwendet werden. Dafür werden die Elektroden 90, 91 mit der Vorrichtung 96 verbunden, die die elektrische Spannung D_{d}. Diese Vorrichtung kann durch einen Geber 98 angesteuert werden, der akustisch mit der Oberfläche des anzutreibenden Elements 8 verbunden ist.

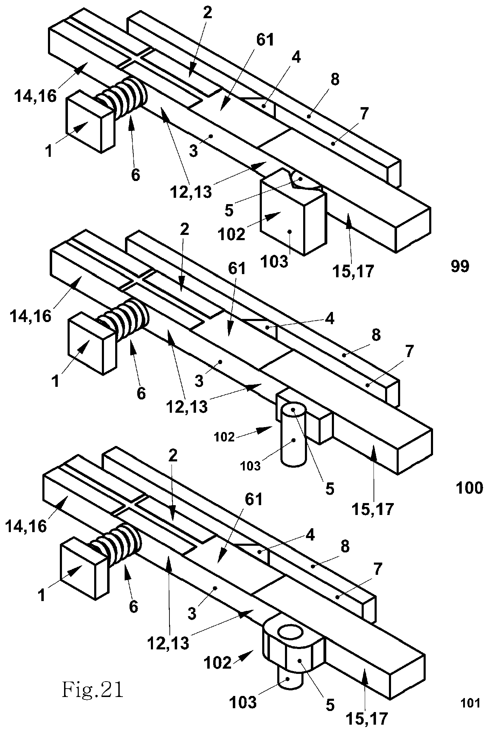

Die Darstellungen 99 bis 101 von Fig. 21 zeigen unterschiedliche Ausführungsformen der Klemmvorrichtung umfassend das Klemmelement 5 und das Federelement 6. Hierbei ist das Klemmelement 5 fest mit der piezoelektrischen Platte 3 des Ultraschallaktors 2 verbunden. Ein Halteelement 103 haltert bzw. lagert das Klemmelement 5. Das Federelement 6 in Form einer Spiralfeder drückt auf den Ultraschallaktor 2 und presst damit das Friktionselement 4 an die Friktionsschicht des anzutreibenden Elements 8.

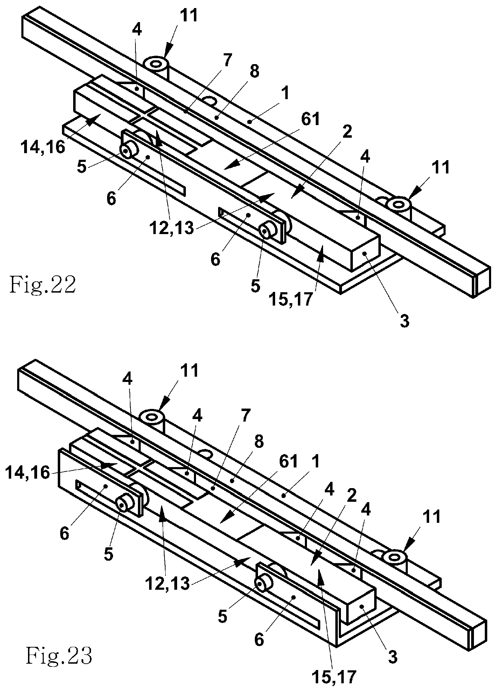

Die Fig. 22 zeigt einen Ultraschallmotor mit einem erfindungsgemäßen Ultraschallaktor 2, der zwei Friktionselemente 4 aufweist. Der Ultraschallmotor umfasst das Gehäuse 1, auf dem der Ultraschallaktor 2 zusammen mit dem anzutreibenden Element 8 und den Lagerelementen 11 angeordnet ist. Die Klemmvorrichtung ist integral bzw. einstückig mit dem Gehäuse 1 ausgeführt, wobei zwei Federelemente 6 aus den gegenüberliegenden Schenkeln eines im Wesentlichen T-förmigen Abschnitts des Gehäuses 1 gebildet sind. Das Klemmelement 5 ragt durch den jeweiligen Endabschnitt der Federelemente 6 hindurch.

Fig. 23 zeigt einen Ultraschallmotor, der geringfügig gegenüber dem aus Fig. 22 abgewandelt ist, weshalb hier nur die diesbezüglichen Unterschiede beschrieben werden. Der Ultraschallaktor 2 weist vier Friktionselemente 4 auf, und die beiden Federelemente 6 sind jeweils aus einem im Wesentlichen L-förmigen Abschnitt des Gehäuses 1 gebildet.

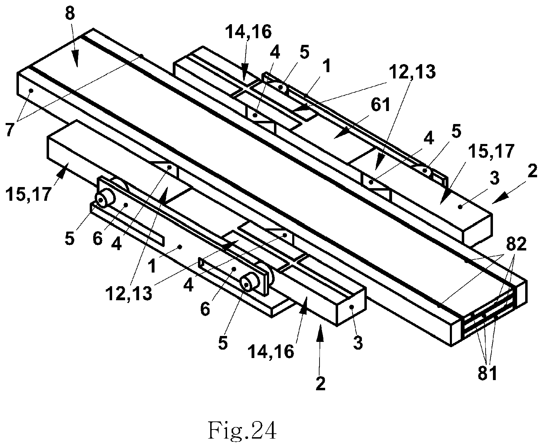

Fig. 24 zeigt eine mögliche Ausführungsform eines Ultraschallmotors mit zwei gegenüberliegend angeordneten erfindungsgemäßen Ultraschallaktoren 2, wobei jeder der Ultraschallaktoren zwei Friktionselemente 4 aufweist. Das anzutreibende Element 8 ist plattenförmig ausgeführt und umfasst neben der Friktionsschicht 7 an dessen Oberfläche mehrere elastische Schichten 81 und Dämpfungsschichten 82 in seinem Inneren.

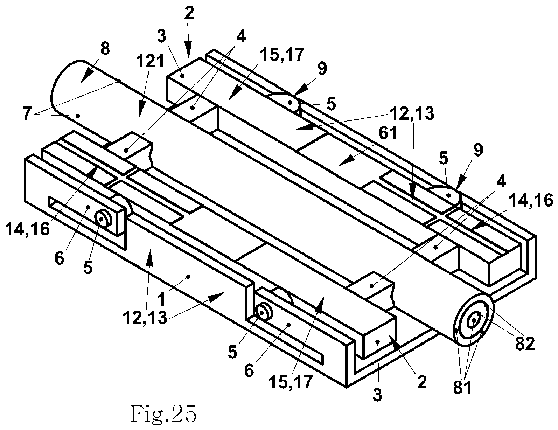

Fig. 25 zeigt einen Ultraschallmotor, der ebenso zwei gegenüberliegend angeordnete erfindungsgemäße Ultraschallaktoren 2 aufweist, und wobei das zwischen diesen angeordnete anzutreibende Element 8 die Form eines Rundstabs mit einer Friktionsschicht 7 und mehreren elastischen Schichten 81 und Dämpfungsschichten 82 hat. Die Friktionselemente 4 weisen jeweils eine V-förmige Nut auf, um das runde anzutreibende Element darin aufzunehmen bzw. zu lagern.

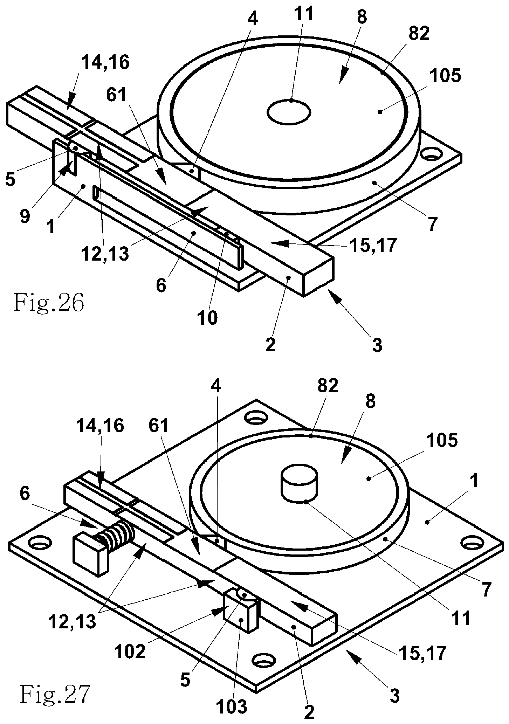

In Fig. 26 ist ein Ultraschallmotor umfassend das Gehäuse 1, den erfindungsgemäßen Ultraschallaktor 2 und ein anzutreibendes Element 8 in Form einer Scheibe, welche in ihrem Mittelpunkt drehbar gelagert ist und an ihrem Außenumfang die Friktionsschicht 7 aufweist, gezeigt. Der erfindungsgemäße Ultraschallaktor 2 hat hierbei eine rechteckige Geometrie.

Fig. 27 zeigt eine Abwandlung des Ultraschallmotors nach Fig. 26, wobei hier das Anpressen des erfindungsgemäßen Ultraschallaktors 2 an das anzutreibende Element 8 über eine alternative Klemmvorrichtung realisiert ist, welche eine Spiralfeder als Federelement 6 umfasst und bei welcher das Klemmelement 5 über das Halteelement 103 gehaltert bzw. gelagert ist.

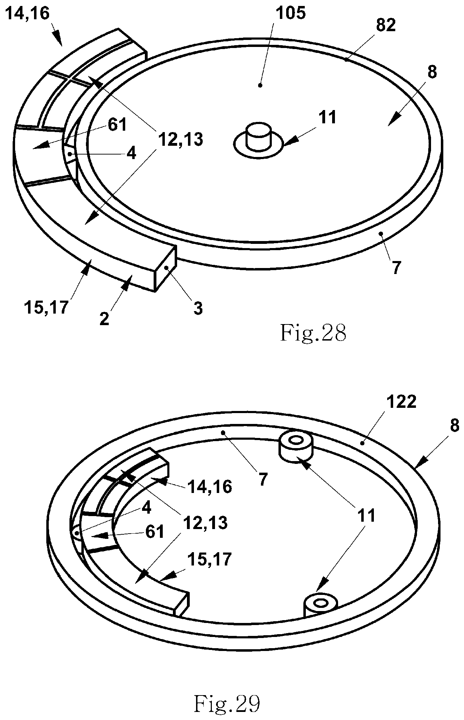

Fig. 28 zeigt eine Anordnung eines erfindungsgemäßen Ultraschallaktor 2 in Form eines Ringsegments zusammen mit einem in seinem Mittelpunkt gelagerten scheibenförmigen anzutreibenden Element 8, wobei der Ultraschallaktor 2 über das Friktionselement 4 den Außenumfang des anzutreibenden Elements 8 bzw. dessen Friktionsschicht 7 kontaktiert.

Fig. 29 zeigt eine Anordnung eines erfindungsgemäßen Ultraschallaktors 2 zusammen mit einem ringförmigen anzutreibenden Element 8, wobei der Ultraschallaktor 2 über das Friktionselement 4 hier den Innenumfang des anzutreibenden Elements 8 bzw. dessen entsprechend angeordnete Friktionsschicht 7 kontaktiert. Das anzutreibende Element 8 ist hierbei über die zwei Lagerelemente 11 in Form von Zylinderrollenlagern gelagert, die ebenso an der Innenumfangsfläche des anzutreibenden Elements 8 angreifen.

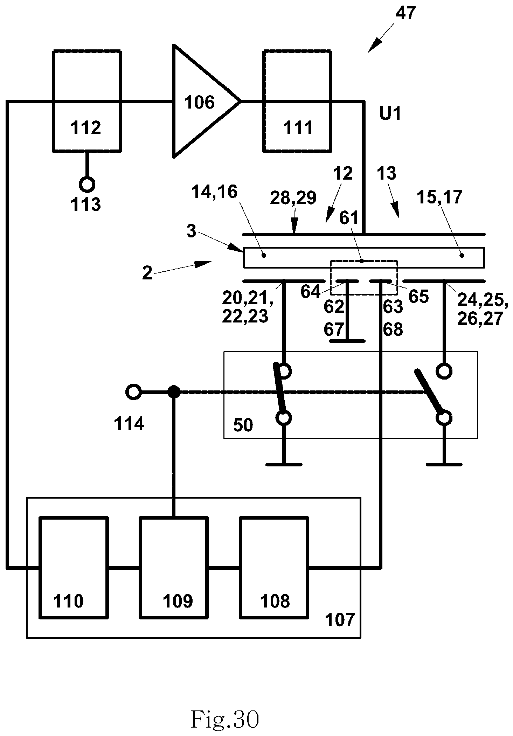

Fig. 30 zeigt eine Blockschaltung der Erregervorrichtung 47 für eine einphasige elektrische Erregung eines der Generatoren 12 oder 13 des Aktors 2. Die Schaltung umfasst einen Leistungsverstärker 106, dessen am Ausgang vorhandene Spannung U₁ an die Elektroden 20-23, 28, 29 oder 24-29 der Generatoren 12 oder 13 angelegt ist, wodurch die Anregung des Aktors 2 erfolgt.

Der Sensor 61 des Aktors 2 ist mit einem Rückkopplungskreis 107 verbunden, der ein Filter 108, einen Phasenschieber 109 und einen Begrenzungsverstärker oder Synchronisierungsgenerator 110 umfasst. Zudem weist die Schaltung ein Abstimmglied 111 und einen symmetrischen PWM-Modulator 112 mit einem Steuereingang 113 auf.

Der Sensor 61 stellt die elektrische Biegespannung bereit, die bei der Frequenz fₗ eine Phasenverschiebung von 90° oder 270° hat. Das Filter 108 trennt von dieser Spannung die höheren Harmonischen ab. Der Phasenschieber 109 verschiebt die Phase der an seinen Eingang angelegten Spannung, wobei die Phasenverschiebung im offenen Rückkopplungskreis gleich Null ist. Der Begrenzungsverstärker bzw. Synchronisierungsgenerator 110 stellt eine Rechteckspannung bereit, die den Leistungsverstärker 106 zum Schwingen bringt.

Das Abstimmglied 111 kann einen elektrischen Transformator und ein Filter enthalten, die zur Abstimmung der Impedanz des Leistungsverstärkers 106 und der Generatoren 12 oder 13 vorgesehen sind.

Der symmetrische PWM-Modulator dient zur Steuerung des Erregerniveaus des Aktors 2. Der Steuereingang 114 des Umschalters 50 dient zur elektronischen Regelung dieses Umschalters. Die Erregervorrichtung 47 stellt einen selbsterregenden Generator für eine elektrische Spannung dar, die durch den Sensor 61 erzeugt wird oder durch diesen synchronisiert wird. Die Erregervorrichtung hält die Frequenz der Spannung U₁ des angesteuerten Aktors 2 so, dass sie gleich fₐ ist.

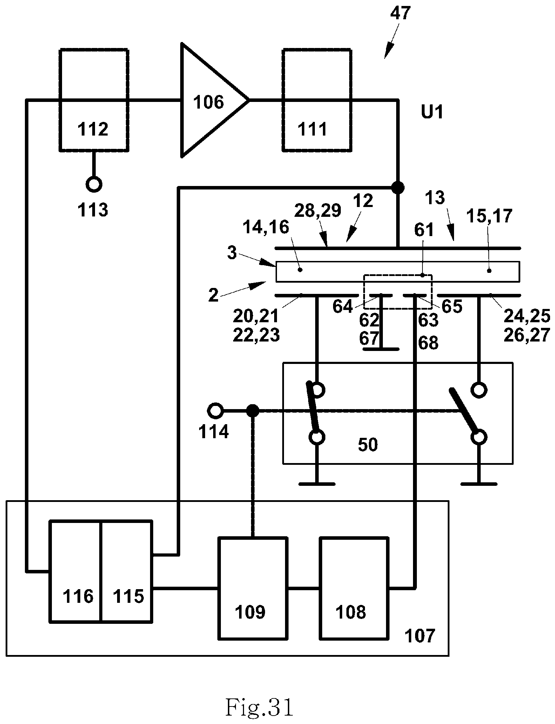

Fig. 31 zeigt die Blockschaltung einer weiteren Variante der Erregervorrichtung 47 für die einphasige elektrische Erregung des Aktors 2. Diese Erregervorrichtung besteht aus einem Phasendetektor 115 und einem Steuergenerator 116. Sie stellt eine PPL-Regelvorrichtung für die Frequenz fₐ dar.

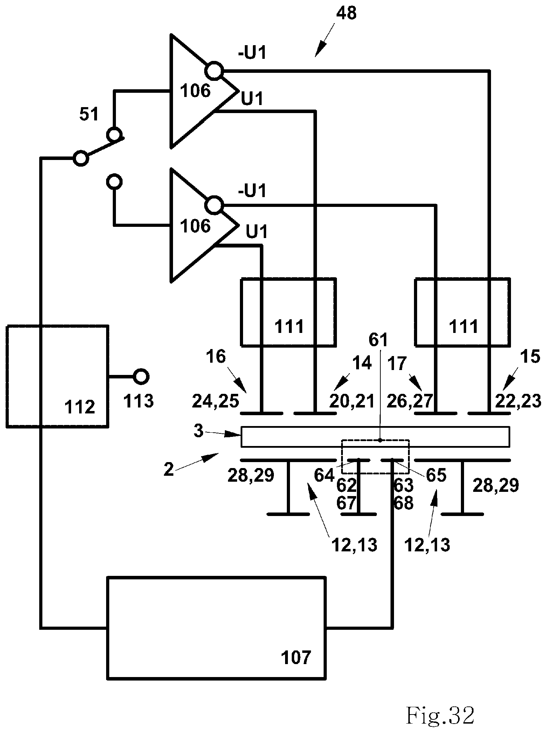

Fig. 32 zeigt die Blockschaltung einer Erregervorrichtung 48 für eine zweiphasige elektrische Erregung eines der Generatoren 12 oder 13 des Aktors 2.

## Patentansprüche

1. Ultraschallaktor (2) in Form einer piezoelektrischen Platte (3) der Länge L, der Höhe H und mit einer Quer-Symmetrieebene S, die senkrecht zur Längsrichtung des Ultraschallaktors (2) durch dessen Mitte verläuft, wobei der Ultraschallaktor (2) zwei Generatoren (12, 13) für akustische Stehwellen umfasst und an dem Ultraschallaktor (2) wenigstens ein Friktionselement (4) zum Antrieb eines anzutreibenden Elements (8) angeordnet ist, wobei jeder der Generatoren (12, 13) zwei Teile (14, 15, 16, 17) umfasst, die auf unterschiedlichen Seiten der Quer-Symmetrieebene S angeordnet sind, und die Länge L und die Höhe H der piezoelektrischen Platte (3) derart bemessen sind, dass die Resonanzfrequenz fₗ der zweiten Mode der Längswelle im Wesentlichen identisch zu der Resonanzfrequenz f_{b} der fünften Mode der Biegestehwelle ist, **dadurch gekennzeichnet, dass** jeder der Generatoren (12, 13) gleichzeitig in dem Ultraschallaktor (2) eine sich jeweils längs der Plattenlänge L ausbreitende Längsstehwelle und eine Biegestehwelle erzeugt.

2. Ultraschallaktor nach Anspruch 1, **dadurch gekennzeichnet, dass** das Verhältnis L/H im Wesentlichen gleich zehn ist.

3. Ultraschallaktor nach Anspruch 1 oder 2, **dadurchgekennzeichnet,** dass die piezoelektrische Platte (3) die Form eines Rechtecks oder eines Ringsegments hat.

4. Ultraschallaktor nach einem der Ansprüche 1 bis 3, **dadurch gekennzeichnet, dass** der Ultraschallaktor (2) einen Sensor (61) für die durch die Biegestehwelle im Ultraschallaktor (2) erzeugte elektrische Spannung aufweist, der im zentralen Teil der piezoelektrischen Platte symmetrisch zur Quer-Symmetrieebene S angeordnet ist.

5. Ultraschallaktor nach einem der Ansprüche 1 bis 4, **dadurch gekennzeichnet, dass** das wenigstens eine Friktionselement (4) an einer Längsseitenfläche (19) der piezoelektrischen Platte (3) angeordnet ist.

6. Ultraschallmotor, umfassend wenigstens einen Ultraschallaktor (2) nach einem der Ansprüche 1 bis 5, ein anzutreibendes Element (8) und eine elektrische Erregervorrichtung (47, 48, 49) zur elektrischen Ansteuerung des Ultraschallaktors (2).

7. Ultraschallmotor nach Anspruch 6, **dadurchgekennzeichnet,** dass dieser eine Klemmvorrichtung zum Anpressen des wenigstens einen Friktionselements (4) an das anzutreibende Element (8) aufweist, wobei die Klemmvorrichtung mindestens ein Klemmelement (5) und wenigstens ein Federelement (6) umfasst.

8. Ultraschallmotor nach Anspruch 7, **dadurch gekennzeichnet, dass** das mindestens eine Klemmelement (5) im Bereich des Minimums der Längsverschiebungen der sich in der piezoelektrischen Platte ausbreitenden akustischen Längsstehwelle angeordnet ist.

9. Ultraschallmotor nach einem der Ansprüche 6 bis 8, **dadurch gekennzeichnet, dass** das anzutreibende Element (8) längs seiner Längsrichtung oder quer zu seiner Längsrichtung oder geneigt zu seiner Längsrichtung angeordnete Nuten (75, 76, 77), die vorzugsweise mit einem Material niedriger mechanischer Güte wie beispielsweise Oxidkeramik, poröse Keramik, Epoxidharz oder elastomeres Material ausgefüllt sind, zur Unterdrückung von parasitären akustischen Wellen aufweist.

10. Ultraschallmotor nach einem der Ansprüche 6 bis 9, **dadurch gekennzeichnet, dass** das anzutreibende Element (8) mehrschichtig ist und zumindest eine Dämpfungsschicht (82) aufweist, die parallel und/oder senkrecht zu einer an der Oberfläche des anzutreibenden Elements (8) angeordneten Friktionsschicht (7) angeordnet ist.

11. Ultraschallmotor nach einem der Ansprüche 6 bis 10, **dadurch gekennzeichnet, dass** das anzutreibende Element (8) wenigstens ein Dämpfungselement (83) aufweist.

12. Ultraschallmotor nach Anspruch 11, **dadurch gekennzeichnet, dass** das Dämpfungselement (83) ein piezoelektrisches Material, vorzugsweise in Form einer piezoelektrischen Platte, aufweist.

13. Ultraschallmotor nach Anspruch 12, **dadurch gekennzeichnet, dass** das Dämpfungselement Elektroden (90, 91) aufweist, die mit die elektrische Energie streuenden Widerständen oder mit einer Vorrichtung zur Erzeugung einer gegenphasigen elektrischen Spannung (96) verbunden sind.

14. Ultraschallmotor nach einem der Ansprüche 6 bis 13, **dadurchgekennzeichnet,** dass die elektrische Erregervorrichtung (47, 48, 49) einen selbsterregenden Generator darstellt, dessen Erregung durch das Signal des Sensors (61) für die durch die Biegestehwelle im Ultraschallaktor erzeugte elektrische Spannung erfolgt oder mit einem Signal des Sensors (61) synchronisiert ist.

15. Ultraschallmotor nach einem der Ansprüche 6 bis 13, **dadurch gekennzeichnet, dass** die elektrische Erregervorrichtung (47, 48, 49) aus einem Steuergenerator für eine elektrische Spannung besteht, dessen Erregerfrequenz durch die Phase des Signals des Sensors (61) für die durch die Biegestehwelle im Ultraschallaktor erzeugte elektrische Spannung gesteuert ist

## Claims

1. Ultrasonic actor (2) in the form of a piezoelectric plate (3) of length L, height H and having a transverse symmetry plane S which extends perpendicular to the longitudinal direction of the ultrasonic actor (2) through the center thereof, wherein the ultrasonic actor (2) comprises two generators (12, 13) for acoustic standing waves and wherein at the ultrasonic actor (2) at least one friction element (4) for driving an element (8) to be driven is arranged, wherein each of the generators (12, 13) comprises two parts (14, 15, 16, 17) which are disposed on different sides of the transverse symmetry plane S, and wherein the length L and the height H of the piezoelectric plate (3) are dimensioned such that the resonance frequency fₗ of the second mode of the longitudinal wave is substantially identical to the resonance frequency f_{b} the fifth mode of the stationary bending wave, **characterized in that** each of the generators (12, 13) generates at the same time in the ultrasonic actor (2) a stationary longitudinal wave and a stationary bending wave each propagating along the plate length L.

2. Ultrasonic actor according to claim 1, **characterized in that** the ratio L/H is substantially equal to ten.

3. Ultrasonic actor according to claim 1 or 2, **characterized in that** the piezoelectric plate (3) has the shape of a rectangle or a ring segment.

4. Ultrasonic actor according to one of claims 1 to 3, **characterized in that** the ultrasonic actor (2) has a sensor (61) for the electrical voltage which is generated by the stationary bending wave in the ultrasonic actor (2), wherein the sensor is disposed in the central part of the piezoelectric plate symmetrical to the transverse symmetry plane S.

5. Ultrasonic actor according to one of claims 1 to 4, **characterized in that** the at least one friction element (4) is arranged on a longitudinal side surface (19) of the piezoelectric plate (3).

6. Ultrasonic motor, comprising at least one ultrasonic actor (2) according to one of claims 1 to 5, an element (8) to be driven and an electrical excitation device (47, 48, 49) for the electrical control of the ultrasonic actor (2).

7. Ultrasonic motor according to claim 6, **characterized in that** the same comprises a clamping device for pressing the at least one friction element (4) to the element (8) to be driven, wherein the clamping device comprises at least one clamping element (5) and at least one spring element (6).

8. Ultrasonic motor according to claim 7, **characterized in that** the at least one clamping element (5) is disposed in the region of the minimum of the longitudinal displacements of the acoustic stationary longitudinal wave which propagates in the piezoelectric plate.

9. Ultrasonic motor according to one of claims 6 to 8, **characterized in that** the element (8) to be driven, for suppression of parasitic acoustic waves, comprises grooves (75, 76, 77) which are disposed along the longitudinal direction of the driven element or transversely to the longitudinal direction of the driven element or inclined to the longitudinal direction of the driven element, and which preferably are filled with a material of low mechanical quality such as oxide ceramic, porous ceramic, epoxy resin or elastomeric material.

10. Ultrasonic motor according to one of claims 6 to 9, **characterized in that** the element (8) to be driven is multi-layered and comprises at least one damping layer (82) which is parallel and/or perpendicular to a friction layer (11) which is disposed at the surface of the driven element (8, 7).

11. Ultrasonic motor according to one of claims 6 to 10, **characterized in that** the element (8) to be driven comprises at least one damping element (83).

12. Ultrasonic motor according to claim 11, **characterized in that** the damping element (83) comprises a piezoelectric material, preferably in the form of a piezoelectric plate.

13. An ultrasonic motor according to claim 12, **characterized in that** the damping element comprises electrodes (90, 91) which are connected to resistors which are dissipating the electrical energy or to a device for generating an anti-phase electrical voltage (96).

14. Ultrasonic motor according to one of claims 6 to 13, **characterized in that** the electrical excitation device (47, 48, 49) represents a self-exciting generator whose excitation is effected by the signal of the sensor (61) for the electrical voltage which is generated by the stationary bending wave in the ultrasonic actor or which is synchronized with a signal of the sensor (61).

15. Ultrasonic motor according to one of claims 6 to 13, **characterized in that** the electrical excitation device (47, 48, 49) comprises an control generator for an electric voltage, whose excitation frequency is controlled by the phase of the signal of the sensor (61) for the electrical voltage caused by the stationary bending wave in the ultrasonic actor.

## Revendications

1. Actionneur ultrasonique (2) sous la forme d'une plaque piézo-électrique (3) de longueur L, de hauteur H et pourvue d'un plan de symétrie transversale S, qui s'écoule à la perpendiculaire de la direction longitudinale de l'actionneur ultrasonique (2) à travers le milieu de celui-ci, l'actionneur ultrasonique (2) comprenant deux générateurs (12, 13) pour des ondes acoustiques stationnaires et sur l'actionneur ultrasonique (2) étant placé au moins un élément de friction (4) destiné à entraîner un élément (8) qui doit être entraîné, chacun des générateurs (12, 13) comprenant deux parties (14, 15, 16, 17) qui sont placées sur différents côtés du plan de symétrie transversale S, et la longueur L et la hauteur H de la plaque piézo-électrique (3) étant dimensionnées de telle sorte que la fréquence de résonance fₗ du deuxième mode de l'onde longitudinale soit sensiblement identique à la fréquence de résonance f_{b} du cinquième mode de l'onde stationnaire de flexion, **caractérisé en ce que** chacun des générateurs (12, 13) génère simultanément dans l'actionneur ultrasonique (2) une onde stationnaire longitudinale se propageant respectivement le long de la longueur de la plaque L et une onde stationnaire de flexion.

2. Actionneur ultrasonique selon la revendication 1, **caractérisé en ce que** le rapport L/H est sensiblement égal à dix.

3. Actionneur ultrasonique selon la revendication 1 ou 2, **caractérisé en ce que** la plaque piézo-électrique (3) a la forme d'un rectangle ou d'un segment annulaire.

4. Actionneur ultrasonique selon l'une quelconque des revendications 1 à 3, **caractérisé en ce que** l'actionneur ultrasonique (2) comporte un capteur (61) de la tension électrique générée par l'onde stationnaire de flexion dans l'actionneur ultrasonique (2) qui est placé dans la partie centrale de la plaque piézo-électrique, en symétrie par rapport au plan de symétrie transversale S.

5. Actionneur ultrasonique selon l'une quelconque des revendications 1 à 4, **caractérisé en ce que** l'au moins un élément de friction (4) est placé sur une surface de côté longitudinal (19) de la plaque piézo-électrique (3).

6. Moteur à ultrasons, comprenant au moins un actionneur ultrasonique (2) selon l'une quelconque des revendications 1 à 5, un élément (8) à entraîner et un dispositif excitateur électrique (47, 48, 49) pour l'amorçage électrique de l'actionneur ultrasonique (2).

7. Moteur à ultrasons selon la revendication 6, **caractérisé en ce que** ce dernier comporte un dispositif de serrage destiné à presser l'au moins un élément de friction (4) contre l'élément (8) qui doit être entraîné, le dispositif de serrage comprenant au moins un élément de serrage (5) et au moins un élément à ressort (6).

8. Moteur à ultrasons selon la revendication 7, **caractérisé en ce que** l'au moins un élément de serrage (5) est placé dans la région du minimum des translations longitudinales de l'onde stationnaire longitudinale acoustique se propageant dans la plaque piézo-électrique.

9. Moteur à ultrasons selon l'une quelconque des revendications 6 à 8, **caractérisé en ce que** l'élément (8) qui doit être entraîné comporte des rainures (75, 76, 77), placées le long de sa direction longitudinale ou à la transversale de sa direction longitudinale ou en inclinaison par rapport à sa direction longitudinale, qui sont remplies de préférence d'une matière de basse qualité mécanique, comme par exemple de la céramique oxydée, de la céramique poreuse, de la résine époxy ou une matière élastomère, pour inhiber des ondes acoustiques parasitaires.

10. Moteur à ultrasons selon l'une quelconque des revendications 6 à 9, **caractérisé en ce que** l'élément (8) qui doit être entraîné est multicouches et comporte au moins couche d'amortissement (82) qui est placé à la parallèle et/ou à la perpendiculaire d'une couche de friction (7) placée en surface de l'élément (8) qui doit être entraîné.

11. Moteur à ultrasons selon l'une quelconque des revendications 6 à 10, **caractérisé en ce que** l'élément (8) qui doit être entraîné comporte au moins un élément amortisseur (83).

12. Moteur à ultrasons selon la revendication 11, **caractérisé en ce que** l'élément amortisseur (83) comporte une matière piézo-électrique, de préférence sous la forme d'une plaque piézo-électrique.

13. Moteur à ultrasons selon la revendication 12, **caractérisé en ce que** l'élément amortisseur comporte des électrodes (90, 91) qui sont reliées avec des résistances disséminant de l'énergie électrique ou avec un dispositif destiné à générer une tension électrique (96) en opposition de phase.

14. Moteur à ultrasons selon l'une quelconque des revendications 6 à 13, **caractérisé en ce que** le dispositif excitateur électrique (47, 48, 49) représente un générateur auto-excité, dont l'excitation a lieu par le signal du capteur (61) pour la tension électrique générée par l'onde stationnaire de flexion dans l'actionneur ultrasonique ou est synchronisée avec un signal du capteur (61).

15. Moteur à ultrasons selon l'une quelconque des revendications 6 à 13, **caractérisé en ce que** le dispositif excitateur électrique (47, 48, 49) est constitué d'un générateur de commande d'une tension électrique dont la fréquence d'excitation est commandée par la phase du signal du capteur (61) pour la tension électrique générée par l'onde stationnaire de flexion dans l'actionneur ultrasonique.
